# FASCICULE DE BREVET EUROPEEN

(11) **EP 3 714 079 B1**
(45) Date de publication et mention de la délivrance du brevet: **15.12.2021**
(21) Numéro de dépôt: 19769510.9
(22) Date de dépôt: 19.09.2019
(51) Int. Cl.: C23C 14/02, C03C 23/00, C23C 14/48, G02B 1/113, G04B 39/00, G02B 1/12, G02B 1/14

(54) **PROCEDE DE DURCISSEMENT D'UN TRAITEMENT ANTIREFLET DEPOSE SUR UN SUBSTRAT TRANSPARENT**
VERFAHREN ZUR HÄRTUNG EINER AUF EINEM TRANSPARENTEN SUBSTRAT AUFGEBRACHTEN ANTIREFLEXIONSBEHANDLUNG
METHOD FOR HARDENING AN ANTI-REFLECTION TREATMENT DEPOSITED ON A TRANSPARENT SUBSTRATE

(30) Priorité: 10.10.2018 EP 18199708
(43) Date de publication de la demande: 30.09.2020
(73) Titulaire: Comadur S.A., 2400 Le Locle (CH)
(72) Inventeur: BOULMAY, Alexis, 25500 Morteau (FR); MEIER, Julien, 2000 Neuchâtel (CH); VUILLE, Pierry, 2338 Les Emibois (CH)
(74) Mandataire: ICB SA
(86) Numéro de dépôt international: PCT/EP2019/075256
(87) Numéro de publication internationale: WO 2020/074235

(56) Documents cités:
- CH-B1- 713 040
- FR-A1- 2 917 510
- US-B2- 9 221 715

## Description

### Domaine technique de l'invention

La présente invention concerne un procédé de durcissement d'un traitement antireflet déposé sur un substrat transparent. Plus précisément, la présente invention concerne un procédé de durcissement d'un traitement antireflet déposé par évaporation sous vide sur un substrat en saphir. On obtient un substrat transparent revêtu d'un traitement antireflet durci.

### Arrière-plan technologique de l'invention

Les premiers traitements antireflets appliqués aux glaces de montres datent de quelques décennies. Ces traitements antireflets ont pour but d'améliorer la lisibilité d'un cadran de montre lorsqu'il est vu par le porteur de la montre à travers la glace ainsi traitée. En effet, un rayon de lumière qui provient de l'extérieur et qui passe à travers la glace de montre subit une première réflexion à l'interface entre l'air et le matériau dans lequel est réalisé la glace, et une seconde réflexion lorsqu'il émerge de la glace et qu'il se propage en direction du cadran. Après réflexion sur le cadran, le rayon lumineux traverse à nouveau la glace et subit encore une fois une double réflexion.

On comprend que ces phénomènes de réflexions multiples nuisent fortement à la lisibilité des informations affichées par le cadran d'une montre. C'est pourquoi on a cherché très tôt à munir les glaces de montres de traitements antireflets. L'intérêt pour cette technologie s'est d'ailleurs accru lorsque sont apparues les glaces de montres en saphir. En effet, en raison de son indice de réfraction optique relativement élevé, un verre en saphir renvoie -comparativement au verre minéral- près du double de lumière, provoquant ainsi une importante réflexion de la lumière à son interface avec l'air.

Une glace de montre comprend une surface supérieure, située du côté du porteur de la montre, et une surface inférieure située du côté du cadran de la montre. Le traitement antireflet d'une glace de montre consiste à revêtir l'une au moins des surfaces supérieure et inférieure de la glace d'au moins une couche d'au moins un matériau dont l'indice de réfraction optique est compris entre celui de l'air et celui du matériau dans lequel est réalisée la glace de montre.

La présente invention s'intéresse tout particulièrement, mais non exclusivement, aux glaces de montres. Plus généralement, la présente invention s'intéresse à tout type de substrat transparent en saphir dont on souhaite réduire les propriétés de réflectivité de la lumière incidente. Par substrat transparent, on entend un substrat qui laisse passer la lumière et paraître avec netteté les objets qui se trouvent derrière. La présente invention s'intéresse également tout particulièrement, mais non exclusivement, aux glaces de montres réalisées en saphir. Il existe cependant également des substrats réalisés en tout matériau transparent tel que le verre minéral, le verre organique ou bien encore les matériaux plastiques qui ne sont pas couverts par l'invention.

Par traitement antireflet, on entend un procédé qui vise à modifier les propriétés de réflexion optique d'un substrat transparent, en particulier une glace de montre, dans le but de réduire la réflectivité d'un tel substrat transparent par rapport à un substrat transparent identique non traité.

Les procédés de traitement antireflet auxquels on s'intéresse ici consistent à déposer sous vide au moins une couche d'au moins un matériau sur l'une des faces supérieure et inférieure d'un substrat transparent. Parmi les procédés de traitement antireflet sous vide auxquels on s'intéresse ici, on peut citer le dépôt physique en phase vapeur, également connu sous la dénomination anglo-saxonne Physical Vapor Déposition ou PVD, le dépôt chimique en phase vapeur, également connu sous la dénomination anglo-saxonne Chemical Vapor Déposition ou CVD, le dépôt chimique en phase vapeur assisté par plasma, également connu sous la dénomination anglo-saxonne Plasma-Enhanced Chemical Vapor Déposition ou PECVD, ou bien encore les techniques de dépôt de couches atomiques, également connues sous leur dénomination anglo-saxonne Atomic Layer Déposition ou ALD.

Comme on l'aura compris de ce qui précède, les techniques de traitement antireflet dont il est question ici consistent à déposer sous vide une ou plusieurs couches d'au moins un matériau sur l'une au moins des faces supérieure et inférieure d'un substrat transparent afin de réduire la réflectivité d'un tel substrat transparent par rapport à un rayonnement lumineux incident. Par substrat transparent, on entend notamment les glaces de montres, les dispositifs optiques, notamment ophtalmiques tels que les verres de lunettes, et plus généralement tout dispositif transparent dont on cherche à réduire la réflectivité pour des questions d'ordre technique et/ou esthétique.

Les couches antireflets ont pour avantage de réduire la réflectivité lumineuse des substrats transparents sur lesquels elles sont déposées. Selon l'épaisseur et les matériaux dans lesquels elles sont réalisées, ces couches antireflets peuvent également modifier la couleur des substrats transparents.

Cependant, les couches antireflets ont pour inconvénient d'être moins dures et donc moins résistantes aux rayures que les substrats sur lesquels elles sont déposées. Ceci est tout particulièrement vrai dans le cas où de telles couches antireflets sont déposées sur un substrat en saphir qui est un matériau dont on sait que seul le diamant peut le rayer.

Pour remédier à ce problème, certains fabricants de montres choisissent de n'effectuer un traitement antireflet que sur la surface inférieure de leurs glaces, c'est-à-dire sur la surface qui est en regard du cadran, ce qui n'est pas pleinement satisfaisant.

Le document CH 713040 B1 décrit un procédé d'implantation d'ions sur une surface d'un objet à traiter, ce procédé comprenant l'étape qui consiste à diriger vers la surface de l'objet à traiter un faisceau d'ions multichargés produit par une source d'ions multichargés du type à résonance cyclotron électronique ECR.

Le document US 9,221,715 B2 décrit un substrat sur lequel est déposé un film antireflet. Un procédé de renforcement dans lequel des ions sodium sont remplacés par voie chimique par des ions potassium est appliqué au film antireflet.

### Résumé de l'invention

Il existait donc sur le marché un besoin pour des couches antireflets dont les propriétés optiques soient conservées et qui soient plus dures, et donc plus résistantes aux rayures et aux impacts qui peuvent survenir lors du transport, d'une manipulation ou du porter.

A cet effet, la présente invention concerne un procédé de durcissement d'un traitement antireflet déposé su un substrat transparent en saphir, ce substrat transparent comprenant une surface supérieure et une surface inférieure qui s'étend à distance de la surface supérieure, le traitement antireflet comprenant l'étape qui consiste à déposer par évaporation sous vide au moins une couche antireflet d'au moins un matériau sur l'une au moins des surface supérieure et inférieure du substrat transparent, le procédé de durcissement comprenant également l'étape qui consiste à bombarder la au moins une surface supérieure ou inférieure sur laquelle a été déposée la couche antireflet à l'aide d'un faisceau d'ions monochargés ou multichargés produit par une source d'ions monochargés ou multichargés à résonance cyclotron électronique ECR, les ions étant accélérés sous une tension comprise entre 30 kV et 50 kV et la dose d'ions à implanter étant comprise entre 0,1.10¹⁶ ions/cm² et 2.10¹⁶ ions/cm².

Par ions monochargés, on entend des ions dont le degré d'ionisation est égal à 1. Par ions multichargés, on entend des ions dont le degré d'ionisation est supérieur à 1. Le faisceau d'ions produit par la source d'ions peut être formé d'ions ayant tous le même degré d'ionisation, ou bien être formé d'un mélange d'ions ayant au moins deux degrés d'ionisation différents.

Selon des formes préférentielles d'exécution de l'invention :
- le substrat transparent en saphir est une glace de montre ;
- le matériau à ioniser est choisi parmi le groupe formé par le carbone (C), l'oxygène (O), l'azote (N), l'argon (Ar), l'hélium (He), le xénon (Xe) et le néon (Ne) ;
- la durée de l'implantation ionique n'excède pas 5 secondes ;
- la ou les couches antireflets sont réalisées au moyen d'oxyde de silicium (SiO2) ou de fluorure de magnésium (MgF2) ;
- l'épaisseur des couches antireflets n'excède pas 150 nm ;
- le traitement antireflet qui résulte du dépôt d'une ou de plusieurs couches antireflets possède un indice de réfraction optique qui n'excède pas 1,55 ;
- avant dépôt de la au moins une couche antireflet, on soumet la surface supérieure et/ou inférieure du substrat transparent à un bombardement ionique ;
- on dépose sur celle des surfaces supérieure et/ou inférieure qui a été bombardée ioniquement après traitement antireflet au moins une couche antireflet supplémentaire.

Grâce à ces caractéristiques, la présente invention procure un procédé qui permet de durcir les couches antireflets déposées sur un substrat transparent tel qu'une glace de montre en saphir et, par voie de conséquence, de les rendre plus résistantes aux rayures et aux impacts dont elles peuvent faire l'objet lors du transport, d'une manipulation ou bien encore lors du porter.

En effet, tous les tests de caractérisation mécanique (résistance aux rayures et résistance aux impacts) prévus par la norme horlogère NIHS 61-30 montrent une nette amélioration des propriétés mécaniques des traitements antireflets dans le cas où ces traitements antireflets ont été l'objet d'un bombardement ionique conformément à l'invention. Par ailleurs, on a noté avec satisfaction que les propriétés optiques des couches antireflets n'étaient nullement affectées par le procédé d'implantation ionique selon l'invention.

Par conséquent, ceux des fabricants horlogers qui, pour des raisons de tenue mécanique jugée insuffisante aux rayures et aux impacts des couches antireflets, ne munissaient jusqu'à présent leurs glaces de montres d'un traitement antireflet que sur la surface inférieure de ces glaces tournée du côté du cadran, peuvent maintenant envisager d'effectuer un traitement antireflet aussi sur la surface supérieure des glaces de montres tournée du côté du porteur, ce qui permet d'améliorer sensiblement la lisibilité des informations affichées par les cadrans de montres lorsqu'elles sont vues à travers les glaces.

On obtient un substrat transparent portant un traitement antireflet, ce substrat transparent comprenant une surface supérieure et une surface inférieure qui s'étend à distance de la surface supérieure, l'une au moins des surfaces supérieure et inférieure du substrat transparent étant revêtue d'au moins une couche antireflet d'au moins un matériau, des ions étant implantés dans la au moins une couche antireflet.

### Brève description des figures

D'autres caractéristiques et avantages de la présente invention ressortiront plus clairement de la description détaillée qui suit d'un exemple de mise en œuvre du procédé selon l'invention, cet exemple étant donné à titre purement illustratif et non limitatif seulement en liaison avec le dessin annexé sur lequel :
- la figure 1 est une représentation schématique d'une source d'ions monochargés ou multichargés du type à résonance cyclotron électronique ECR;
- la figure 2A est une vue de dessus d'une glace de montre en saphir plate ayant fait l'objet d'un traitement antireflet et ayant été soumise à un test de résistance aux rayures ;
- la figure 2B est une vue de dessus, à la même échelle, de la même glace de montre en saphir plate ayant fait l'objet du même traitement antireflet que celle illustrée à la figure 2A, puis ayant été soumise à un bombardement ionique conformément à la présente invention, la résistance aux rayures de cette glace de montre ayant ensuite été testée, et
- la figure 3 illustre la différence de dureté entre un traitement antireflet déposé sur une glace de montre en saphir n'ayant pas été bombardé ioniquement, et le même traitement antireflet sur une glace de montre en saphir identique ayant fait l'objet d'une implantation ionique par bombardement.

### Description détaillée d'un mode de réalisation de l'invention

La présente invention procède de l'idée générale inventive qui consiste à implanter par bombardement des ions dans un traitement antireflet déposé sur l'une au moins des surfaces supérieure et inférieure d'un substrat transparent tel qu'une glace de montre en saphir. On s'est en effet rendu compte qu'après bombardement ionique, le traitement antireflet, formé d'une ou de plusieurs couches antireflets, présentait une tenue mécanique sensiblement améliorée aux rayures et aux impacts qui peuvent survenir lors d'une manipulation, du transport ou au porter. En outre, on a observé que les propriétés optiques des couches antireflets n'étaient nullement affectées par le bombardement ionique conforme à l'invention, de sorte que certains fabricants horlogers qui, jusqu'à présent, hésitaient à revêtir la surface supérieure de leurs glaces de montres d'un traitement antireflet en raison de propriétés de tenue mécanique jugées insuffisantes, peuvent maintenant soumettre leurs glaces de montres à un traitement antireflet sur les deux surfaces supérieure et inférieure, de sorte que les phénomènes de réflexions parasites de la lumière sont sensiblement réduits et la lisibilité des informations affichées par le cadran de la montre vues à travers la glace nettement améliorée. Ces résultats sont assez inattendus étant donné la faible épaisseur des couches antireflets qui n'excède pas 150 nm et qui est plus souvent de l'ordre de quelques dizaines de nanomètres. En effet, on craignait que le bombardement ionique ait pour effet, non pas de renforcer la tenue mécanique des couches antireflets, mais bien au contraire ait pour effet de les fragiliser et d'altérer leurs propriétés optiques. Or tel n'est pas le cas, bien au contraire.

La présente invention va être décrite en liaison avec une glace de montre en saphir. Il va de soi que cet exemple est donné à titre purement illustratif et non limitatif seulement, et que la présente invention peut s'appliquer de manière identique à tout type de substrat transparent en saphir. Il existe également des substrats transparents, par exemple en verre minéral, en verre organique ou bien encore en matériau plastique, recevant un traitement antireflet tel que des verres ophtalmiques ou bien des lentilles de dispositifs optiques, par exemple des appareils photographiques qui ne sont pas couverts par l'invention.

De même, la présente invention va être décrite en liaison avec une source d'ions monochargés ou multichargés du type à résonance cyclotron électronique, ou Electron Cyclotron Resonance (ECR) en terminologie anglo-saxonne.

Une source d'ions ECR fait usage de la résonance cyclotronique des électrons pour créer un plasma. Un volume de gaz à basse pression est ionisé au moyen de microondes injectées à une fréquence correspondant à la résonance cyclotron électronique définie par un champ magnétique appliqué à une région située à l'intérieur du volume de gaz à ioniser. Les microondes chauffent les électrons libres présents dans le volume de gaz à ioniser. Ces électrons libres, sous l'effet de l'agitation thermique, vont entrer en collision avec les atomes ou les molécules de gaz et provoquer leur ionisation. Les ions produits correspondent au type de gaz utilisé. Ce gaz peut être pur ou composé. Il peut également s'agir d'une vapeur produite à partir d'un matériau solide ou liquide. La source d'ions ECR est en mesure de produire des ions simplement chargés, c'est-à-dire des ions dont le degré d'ionisation est égal à 1, ou bien des ions multichargés, c'est-à-dire des ions dont le degré d'ionisation est supérieur à 1.

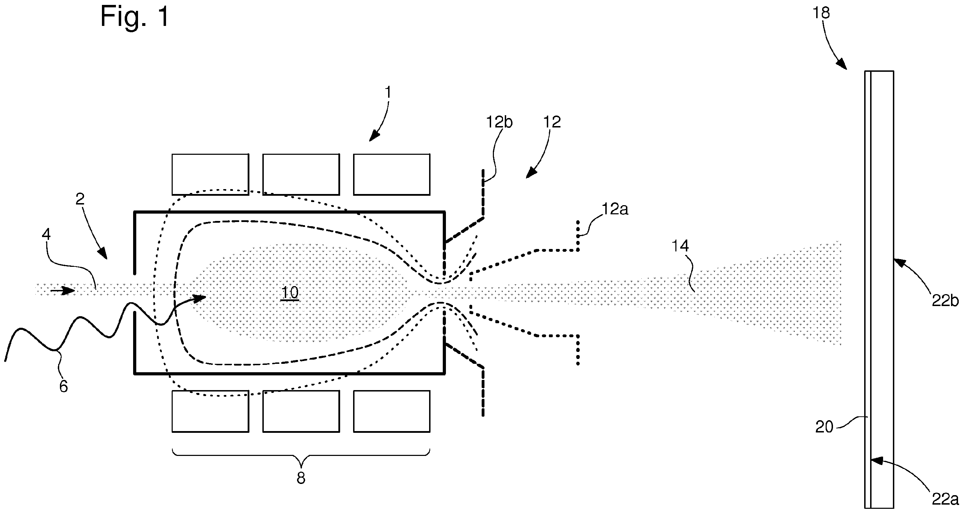

Une source d'ions du type à résonance cyclotron électronique ECR est schématiquement illustrée sur la figure 1 annexée à la présente demande de brevet. Désignée dans son ensemble par la référence numérique générale 1, une source d'ions ECR comprend un étage d'injection 2 dans lequel on introduit un volume 4 d'un gaz à ioniser et une onde hyperfréquence 6, un étage de confinement magnétique 8 dans lequel est créé un plasma 10, et un étage d'extraction 12 qui permet d'extraire et d'accélérer les ions du plasma 10 au moyen d'une anode 12a et d'une cathode 12b entre lesquelles est appliquée une haute tension. Un faisceau d'ions 14 produit en sortie de la source d'ions ECR 1 vient frapper une surface d'un substrat transparent à traiter, ici une glace de montre 18, et pénètre plus ou moins profondément dans le traitement antireflet 20 structuré sur l'une au moins des surfaces supérieure 22a et inférieure 22b de la glace de montre 18 à traiter.

Le gaz à ioniser peut être au choix du carbone (C) obtenu par exemple à partir de dioxyde de carbone (CO2) ou de méthane (CH₄), de l'oxygène (O), de l'argon (Ar), de l'azote (N), de l'hélium (He), du xénon (Xe) ou du néon (Ne). Les ions peuvent être de type monochargé, c'est-à-dire que leur degré d'ionisation est égal à +1, ou bien être de type multichargé, c'est-à-dire que leur degré d'ionisation est supérieur à +1. Le faisceau d'ions produit par la source d'ions ECR 1 peut être formé d'ions ayant tous le même degré d'ionisation, ou bien être formé d'un mélange d'ions ayant au moins deux degrés d'ionisation différents.

Les ions monochargés ou multichargés sont accélérés sous une tension comprise entre 30 kV et 50kV, la dose d'ions à implanter est comprise entre 0,1.10¹⁶ ions/cm² et 2.10¹⁶ ions/cm² et la durée de l'implantation ionique n'excède pas 5 secondes.

La ou les couches antireflets sont réalisées par exemple au moyen de silice (SiO2) ou de fluorure de magnésium (MgF2). Il est possible de combiner des couches en silice avec des couches en fluorure de magnésium. L'épaisseur de ces couches considérées individuellement n'excède habituellement pas 150 nm. D'autres matériaux tels que les oxydes de titane, de tantale, de zircone, de silicium et d'aluminium ainsi que le nitrure de silicium peuvent aussi être utilisés pour la réalisation des couches antireflets. Ces couches antireflets sont déposées par évaporation sous vide. Parmi les techniques de dépôt sous vide envisageables, on peut citer le dépôt physique en phase vapeur, également connu sous la dénomination anglo-saxonne Physical Vapor Déposition ou PVD, le dépôt chimique en phase vapeur, également connu sous la dénomination anglo-saxonne Chemical Vapor Déposition ou CVD, le dépôt chimique en phase vapeur assisté par plasma, également connu sous la dénomination anglo-saxonne Plasma-Enhanced Chemical Vapor Déposition ou PECVD, ou bien encore les techniques de dépôt de couches atomiques, également connues sous leur dénomination anglo-saxonne Atomic Layer Déposition ou ALD.

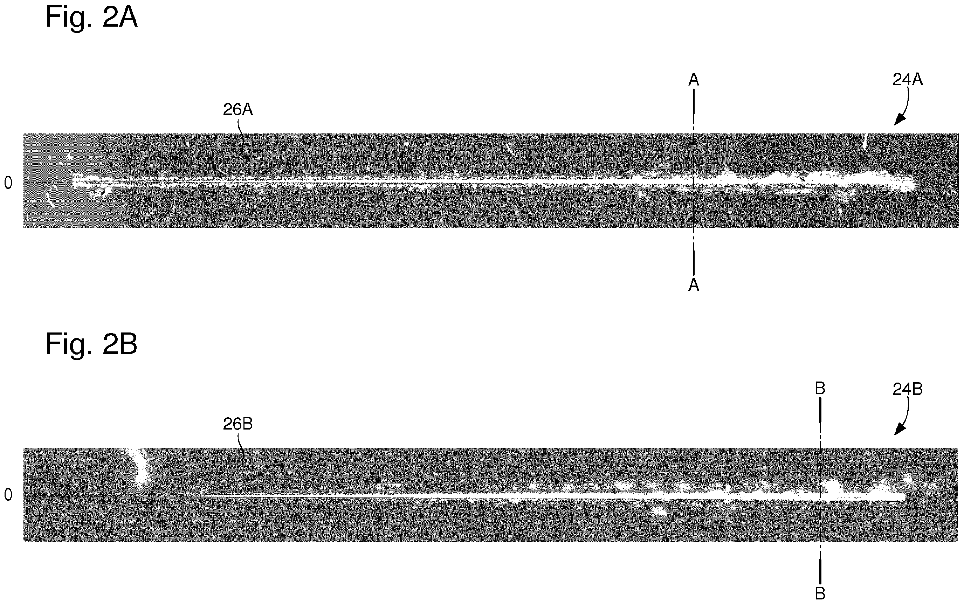

La figure 2A est une vue de dessus d'une glace de montre plate 24A en saphir ayant fait l'objet d'un traitement antireflet 26A formé d'une couche de fluorure de magnésium MgF₂ de 90 µm d'épaisseur et ayant été soumise à un test de résistance aux rayures. Ce test consiste à rayer le traitement antireflet 26A sur une distance de 0,5 mm au moyen d'une pointe en diamant de géométrie sphéro-conique avec un rayon de 5 µm. La pointe en diamant est déplacée à une vitesse de 1 mm/min. Elle est appliquée à l'origine 0 avec une force sensiblement nulle, cette force augmentant de manière linéaire à la vitesse de 401.88 mN/min pour atteindre 200 mN au bout de la distance de 0,5 mm. On note que la pointe en diamant est déplacée de la gauche vers la droite de la figure 2A.

Sur la figure 2A, l'endroit où le saphir de la glace de montre plate 24A est mis à nu est repéré par la ligne A-A. Sur la figure 2B, on a représenté, à la même échelle, la même glace de montre plate 24B en saphir ayant fait l'objet du même traitement antireflet 26B que la glace de montre plate 24A en saphir de la figure 2A. Par contre, la glace de montre plate 24B en saphir de la figure 2B a fait, après traitement antireflet, l'objet d'une implantation ionique par bombardement conformément à l'invention. Les caractéristiques du traitement d'implantation ionique auquel la couche de fluorure de magnésium MgF₂ de 90 µm d'épaisseur a été soumise sont les suivantes :
- type d'ions implantés : azote
- tension d'accélération des ions : 40 kV ;
- dose d'implantation ionique: comprise entre 0,1.10¹⁶ ions/cm² et 0,25.10¹⁶ ions/cm² ;
- intensité du faisceau d'ions : 6 mA ;
- conditions de vide : 4.10⁻⁶ mbar ;
- profondeur de pénétration des ions la couche de fluorure de magnésium MgF₂ : environ 50 nm.

Les conditions expérimentales de mesure de la résistance aux rayures des glaces de montres plates 24A et 24B en saphir des figures 2A et 2B étant identiques, on observe que l'endroit où le saphir de la glace de montre plate 24B est mis à nu, repéré par la ligne B-B sur la figure 2B, survient plus loin de l'origine 0 que dans le cas de la figure 2A, ce qui signifie que la dureté du traitement antireflet 26B est augmentée grâce au bombardement ionique. On observe également, en comparant les figures 2A et 2B, que la rayure laissée par la pointe en diamant est moins large sur la figure 2B que sur la figure 2A, ce qui signifie que le phénomène de délamination du traitement antireflet 26B est moins important dans le cas de la figure 2B, et donc que ce traitement antireflet 26B est plus dur et donc plus résistant aux rayures que dans le cas de la figure 2A.

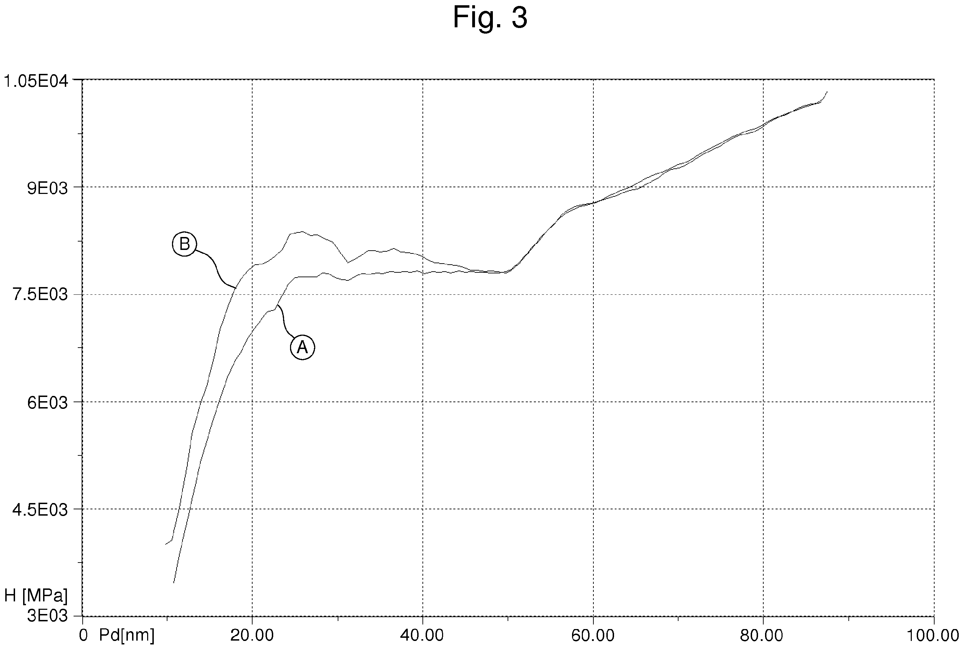

La figure 3 illustre la différence de dureté entre un traitement antireflet déposé sur une glace de montre en saphir n'ayant pas été bombardé ioniquement (courbe A), et le même traitement antireflet sur une glace de montre en saphir identique ayant fait l'objet d'une implantation ionique par bombardement (courbe B). Ces valeurs de dureté obtenues par mesure du module élastique permettent de mettre en évidence l'évolution des propriétés mécaniques des couches antireflets en fonction de la profondeur. Ces valeurs de dureté ont été mesurées par la technique dite d'indentation instrumentée en utilisant un mode DMA (Dynamic Mechanical Analysis) également connue sous la terminologie anglo-saxonne Continuous Stiffness Measurement.

Sur le graphique de la figure 3, on a représenté en abscisse l'épaisseur du traitement antireflet pd exprimée en nanomètres ; en ordonnée, on a reporté la dureté H, exprimée en MpA, des couches formant le traitement antireflet. On comprend immédiatement en examinant ce graphique que depuis la surface du traitement antireflet et jusqu'à une profondeur de 20 nm environ depuis cette surface, le traitement antireflet ayant fait l'objet d'un bombardement ionique (courbe B) est environ 20% plus dur que le traitement antireflet n'ayant pas fait l'objet d'un bombardement ionique (courbe A). A une profondeur comprise entre 20 et 40 nm calculée depuis la surface du traitement antireflet, la différence de dureté entre le traitement antireflet ayant fait l'objet d'un bombardement ionique et le traitement antireflet n'ayant pas fait l'objet d'un tel bombardement ionique est encore de l'ordre de 10%, puis va en diminuant jusqu'à une profondeur de 50 nm. A partir de 50 nm, les courbes de dureté du traitement antireflet ayant été bombardé ioniquement et du traitement antireflet n'ayant pas été bombardé se rejoignent pour ne plus se séparer jusqu'à une profondeur de 90 nm qui est la limite de la mesure de la dureté sur le graphique de la figure 3.

Il va de soi que la présente invention n'est pas limitée au mode de mise en œuvre du procédé qui vient d'être décrit, et que diverses modifications et variantes simples peuvent être envisagées par l'homme du métier sans sortir du cadre de l'invention tel que défini par les revendications annexées à la présente demande de brevet. En particulier, la présente invention enseigne de soumettre la surface du substrat transparent qui est destinée à faire l'objet du traitement antireflet à un bombardement ionique avant dépôt de la ou des couches antireflets. De même, la présente invention enseigne qu'après bombardement ionique de la ou des couches antireflets, il est possible de déposer sur les couches antireflets ainsi traitées par implantation ionique au moins une couche antireflet supplémentaire.

### Nomenclature

1. Source d'ions à résonance cyclotron électronique ECR
2. Etage d'injection
4. Volume de gaz à ioniser
6. Onde hyperfréquence
8. Etage de confinement magnétique 10. Plasma
12. Etage d'extraction
12a. Anode
12b. Cathode
14. Faisceau d'ions
18. Glace de montre
20. Traitement antireflet
22a. Surface supérieure
22b. Surface inférieure
24a, 24b. Glaces de montres plates
26a, 26b. Traitements antireflets
O. Origine
A-A. Ligne qui repère l'endroit où le saphir de la glace de montre plate 24A est mis à nu
B-B. Ligne qui repère l'endroit où le saphir de la glace de montre plate 24B est mis à nu

## Revendications

1. Procédé de durcissement d'un traitement antireflet (20) déposé sur un substrat transparent en saphir, ce substrat transparent comprenant une surface supérieure (22a) et une surface inférieure (22b) qui s'étend à distance de la surface supérieure (22a), le traitement antireflet (20) comprenant l'étape qui consiste à déposer par évaporation sous vide au moins une couche antireflet d'au moins un matériau sur l'une au moins des surfaces supérieure (22a) et inférieure (22b) du substrat transparent, le procédé de durcissement comprenant l'étape qui consiste à bombarder la au moins une surface supérieure (22a) ou inférieure (22b) sur laquelle a été déposée la au moins une couche antireflet à l'aide d'un faisceau d'ions (14) monochargés et/ou multichargés produit par une source d'ions (1) monochargés et/ou multichargés à résonance cyclotron électronique ECR (1), les ions étant accélérés sous une tension comprise entre 30 kV et 50 kV et la dose d'ions à implanter étant comprise entre 0,1.10¹⁶ ions/cm² et 2.10¹⁶ ions/cm².

2. Procédé de durcissement selon la revendication 1, **caractérisé en ce que** la technique de dépôt par évaporation sous vide est choisie parmi le dépôt physique en phase vapeur, le dépôt chimique en phase vapeur, le dépôt chimique en phase vapeur assisté par plasma et la technique de dépôt de couches atomiques.

3. Procédé de durcissement selon l'une des revendications 1 et 2, **caractérisé en ce que**, avant dépôt de la au moins une couche antireflet, on soumet la surface supérieure (22a) et/ou inférieure (22b) destinée à faire l'objet du traitement antireflet à un bombardement ionique.

4. Procédé de durcissement selon l'une des revendications 1 à 3, **caractérisé en ce que** l'on dépose sur le traitement antireflet (20) qui a été bombardé ioniquement au moins une couche antireflet supplémentaire.

5. Procédé de durcissement selon l'une des revendications 1 à 4, **caractérisé en ce que** la source d'ions ECR (1) comprend un étage d'injection (2) dans lequel on introduit un volume (4) d'un gaz à ioniser et une onde hyperfréquence (6), un étage de confinement magnétique (8) dans lequel est créé un plasma (10), et un étage d'extraction (12) qui permet d'extraire et d'accélérer les ions du plasma (10) au moyen d'une anode (12a) et d'une cathode (12b) entre lesquelles est appliquée une haute tension, un faisceau d'ions (14) produit en sortie de la source d'ions ECR (1) venant frapper une surface du substrat transparent à traiter et pénétrant plus ou moins profondément dans le traitement antireflet (20) structuré sur l'une au moins des surfaces supérieure et inférieure (22a, 22b) du substrat transparent à traiter.

6. Procédé de durcissement selon la revendication 5, **caractérisé en ce que** le matériau à ioniser est choisi dans le groupe formé par le carbone (C), l'oxygène (O),l'azote (N), l'argon (Ar), l'hélium (He), le xénon (Xe) et le néon (Ne).

7. Procédé de durcissement selon la revendication 6, **caractérisé en ce que** les ions peuvent être de type monochargé, c'est-à-dire que leur degré d'ionisation est égal à +1, ou bien être de type multichargé, c'est-à-dire que leur degré d'ionisation est supérieur à +1.

8. Procédé de durcissement selon la revendication 7, **caractérisé en ce que** le faisceau d'ions (14) produit par la source d'ions ECR (1) peut être formé d'ions ayant tous le même degré d'ionisation, ou bien être formé d'un mélange d'ions ayant au moins deux degrés d'ionisation différents.

9. Procédé de durcissement selon l'une des revendications 1 à 8, **caractérisé en ce que** la durée de l'implantation ionique n'excède pas 5 secondes.

10. Procédé de durcissement selon l'une des revendications 1 à 9, **caractérisé en ce que** le substrat transparent est une glace de montre (18).

11. Procédé de durcissement selon l'une des revendications 1 à 10, **caractérisé en ce que** la ou les couches antireflets sont réalisées au moyen de silice (SiO2) ou de fluorure de magnésium (MgF2).

12. Procédé de durcissement selon la revendication 10, **caractérisé en ce que** l'épaisseur des couches antireflets n'excède pas 150 nm.

## Patentansprüche

1. Verfahren zur Härtung einer auf einem transparenten Substrat aus Saphir aufgebrachten Antireflexionsbehandlung (20), wobei dieses transparente Substrat eine obere Oberfläche (22a) und eine untere Oberfläche (22b) umfasst, die sich von der oberen Oberfläche (22a) beabstandet erstreckt, wobei die Antireflexionsbehandlung (20) den Schritt umfasst, der darin besteht, durch Vakuumverdampfen mindestens eine Antireflexionsschicht aus mindestens einem Material auf mindestens eine von der oberen (22a) und unteren (22b) Oberfläche des transparenten Substrats aufzubringen, wobei das Härtungsverfahren den Schritt umfasst, der darin besteht, die mindestens eine obere (22a) oder untere (22b) Oberfläche, auf die die mindestens eine Antireflexionsschicht aufgebracht wurde, mit Hilfe eines Strahls (14) einfach geladener und/oder mehrfach geladener Ionen erzeugt von einer Quelle (1) einfach geladener und/oder mehrfach geladener Ionen mit Elektronenzyklotronresonanz ECR (1) zu bombardieren, wobei die Ionen unter einer Spannung beschleunigt werden, die zwischen 30 kV und 50 kV liegt, und die zu implantierende Ionendosis zwischen 0,1.10¹⁶ Ionen/cm² und 2.10¹⁶ Ionen/cm² liegt.

2. Härtungsverfahren nach Anspruch 1, **dadurch gekennzeichnet, dass** die Technik des Aufbringens durch Vakuumverdampfen aus dem physikalischen Aufbringen in Dampfphase, dem chemischen Aufbringen in Dampfphase, dem chemischen plasmaunterstützten Aufbringen in Dampfphase und der Technik des Aufbringens von Atomschichten ausgewählt ist.

3. Härtungsverfahren nach einem der Ansprüche 1 und 2, **dadurch gekennzeichnet, dass** vor dem Aufbringen der mindestens einen Antireflexionsschicht die obere (22a) und/oder untere (22b) Oberfläche, die bestimmte ist, Gegenstand der Antireflexionsbehandlung zu sein, einer lonenbombardierung unterzogen wird.

4. Härtungsverfahren nach einem der Ansprüche 1 bis 3, **dadurch gekennzeichnet, dass** auf die Antireflexbehandlung (20), die ionisch bombardiert wurde, mindestens eine zusätzliche Antireflexionsschicht aufgebracht wird.

5. Härtungsverfahren nach einem der Ansprüche 1 bis 4, **dadurch gekennzeichnet, dass** die lonenquelle ECR (1) eine Injektionsstufe (2) umfasst, in die ein Volumen (4) eines zu ionisierenden Gases und eine Hyperfrequenzwelle (6) eingeführt werden, eine magnetische Einschlussstufe (8), in der ein Plasma (10) erzeugt wird, und eine Extraktionsstufe(12), die erlaubt, die Ionen des Plasmas (10) mittels einer Anode (12a) und einer Kathode (12b) zu extrahieren und zu beschleunigen, zwischen denen eine hohe Spannung angelegt wird, wobei ein am Ausgang der lonenquelle ECR (1) erzeugter lonenstrahl (14) auf eine Oberfläche des zu behandelnden transparenten Substrats auftrifft und mehr oder weniger tief in die Antireflexionsbehandlung (20) eindringt, die auf mindestens einer von der oberen und unteren Oberfläche (22a, 22b) des zu behandelnden transparenten Substrats strukturiert ist.

6. Härtungsverfahren nach Anspruch 5, **dadurch gekennzeichnet, dass** das zu ionisierende Material aus der Gruppe ausgewählt ist, die von Kohlenstoff (C), Sauerstoff (O),Stickstoff (N), Argon (Ar), Helium (He), Xenon (Xe) und Neon (Ne) gebildet ist.

7. Härtungsverfahren nach Anspruch 6, **dadurch gekennzeichnet, dass** die Ionen vom Typ einfach geladen, das heißt, dass ihr Ionisierungsgrad gleich +1 ist, oder vom Typ mehrfach geladen, das heißt, dass ihr Ionisierungsgrad über +1 liegt, sein können.

8. Härtungsverfahren nach Anspruch 7, **dadurch gekennzeichnet, dass** der von der lonenquelle ECR (1) erzeugte lonenstrahl (14) von Ionen gebildet sein kann, die alle denselben Ionisierungsgrad haben, oder von einer lonenmischung gebildet sein kann, die mindestens zwei unterschiedliche lonengrade haben.

9. Härtungsverfahren nach einem der Ansprüche 1 bis 8, **dadurch gekennzeichnet, dass** die Dauer der Ionenimplantation 5 Sekunden nicht überschreitet.

10. Härtungsverfahren nach einem der Ansprüche 1 bis 9, **dadurch gekennzeichnet, dass** das transparente Substrat ein Uhrenglas (18) ist.

11. Härtungsverfahren nach einem der Ansprüche 1 bis 10, **dadurch gekennzeichnet, dass** die Antireflexionsschicht/en mittels Siliziumoxid (SiO2) oder Magnesiumfluorid (MgF₂) hergestellt ist/sind.

12. Härtungsverfahren nach Anspruch 10, **dadurch gekennzeichnet, dass** die Dicke der Antireflexionsschichten 150 nm nicht überschreitet.

## Claims

1. Method for hardening an anti-reflection treatment (20) deposited on a transparent sapphire substrate, this transparent substrate comprising a top surface (22a) and a bottom surface (22b) which extends remotely from the top surface (22a), the anti-reflection treatment (20) comprising the step consisting of depositing by vacuum evaporation at least one anti-reflection layer of at least one material on at least one of the top (22a) and bottom (22b) surfaces of the transparent substrate, the hardening method comprising the step consisting of bombarding the at least one top (22a) or bottom (22b) surface on which the at least one anti-reflection layer has been deposited using a beam (14) of singly-charged and/or multi-charged ions produced by a ECR electron cyclotron resonance ion source (1) of singly-charged and/or multi-charged ions, the ions being accelerated under a voltage that lies in the range 30 kV to 50 kV and the dose of ions to be implanted lying in the range 0.1·10¹⁶ ions/cm² to 2.10¹⁶ ions/cm².

2. Hardening method according to claim 1, **characterised in that** the vacuum evaporation deposition technique is selected from among physical vapour deposition, chemical vapour deposition, plasma-enhanced chemical vapour deposition and atomic layer deposition.

3. Hardening method according to one of claims 1 and 2, **characterised in that**, before deposition of the at least one anti-reflection layer, the top (22a) and/or bottom (22b) surface intended to be subjected to the anti-reflection treatment undergoes ion bombardment.

4. Hardening method according to one of claims 1 to 3, **characterised in that** at least one additional anti-reflection layer is deposited on the anti-reflection treatment (20) having undergone ion bombardment.

5. Hardening method according to one of claims 1 to 4, **characterised in that** the ECR ion source (1) comprises an injection stage (2), into which a volume (4) of a gas to be ionised and a microwave (6) are injected, a magnetic confinement stage (8), wherein a plasma (10) is created, and an extraction stage (12), which allows the ions of the plasma (10) to be extracted and accelerated using an anode (12a) and a cathode (12b) between which a high voltage is applied, an ion beam (14) produced at the output of the ECR ion source (1) striking a surface of the transparent substrate to be treated and penetrating more or less deeply within the anti-reflection treatment (20) structured on at least one of the top and bottom surfaces (22a, 22b) of the transparent substrate to be treated.

6. Hardening method according to claim 5, **characterised in that** the material to be ionised is selected from the group consisting of carbon (C), oxygen (O),nitrogen (N), argon (Ar), helium (He), xenon (Xe) and neon (Ne).

7. Hardening method according to claim 6, **characterised in that** the ions can be of the singly-charged type, i.e. the degree of ionisation thereof is equal to +1, or of the multi-charged type, i.e. the degree of ionisation thereof is greater than +1.

8. Hardening method according to claim 7, **characterised in that** the ion beam (14) produced by the ECR ion source (1) can be formed of ions that all have the same degree of ionisation, or be formed of a mixture of ions having at least two different degrees of ionisation.

9. Hardening method according to any of claims 1 to 8, **characterised in that** the duration of the ion implantation process does not exceed 5 seconds.

10. Hardening method according to any of claims 1 to 9, **characterised in that** the transparent substrate is a watch crystal (18).

11. Hardening method according to one of claims 1 to 10, **characterised in that** the one or more anti-reflection layers are made using silica (SiO2) or magnesium fluoride (MgF₂).

12. Hardening method according to claim 10, **characterised in that** the thickness of the anti-reflection layers does not exceed 150 nm.
